# EUROPÄISCHE PATENTANMELDUNG

(11) **EP 3 783 493 A1**
(43) Veröffentlichungstag der Anmeldung: **24.02.2021**
(21) Anmeldenummer: 20183605.3
(22) Anmeldetag: 02.07.2020
(51) Int. Cl.: G06F 11/36, G06F 11/26

(54) **VERFAHREN ZUM TESTEN EINES SYSTEMS AUF EINE ANFORDERUNG**

(30) Priorität: 21.08.2019 DE 102019212458
(71) Anmelder: Robert Bosch GmbH, 70442 Stuttgart (DE)
(72) Erfinder: Ophey, Julian, 71229 Leonberg (DE); Grimm, Andreas, 75233 Tiefenbronn-Muehlhausen (DE)

(57) **Zusammenfassung**

Vorgestellt wird computerimplementiertes Verfahren zum Testen eines Systems auf mindestens eine Anforderung mit den Schritten:
- die Anforderung wird in maschinenlesbarer Form empfangen,
- für den Test des Systems auf die empfangene Anforderung wird mindestens eine erste Eingangsgröße ermittelt,
- eine Ausführung des Systems wird abhängig von der ermittelten ersten Eingangsgröße simuliert,
- eine Ausgangsgröße des simulierten Systems wird ermittelt und abhängig von der Ausgangsgröße ermittelt, ob das System die Anforderung erfüllt,
- es wird überprüft, ob die Simulation eine Qualitätsanforderung erfüllt,
- falls die Simulation die Qualitätsanforderung erfüllt und das System die Anforderung erfüllt, wird überprüft, ob für die Anforderung eine ausreichende Testabdeckung erreicht ist,
- ist die ausreichende Testabdeckung für die Anforderung erreicht, wird der Test für die Anforderung abgeschlossen.

## Beschreibung

Die Erfindung betrifft computerimplementierte Verfahren zum Testen eines Systems auf eine Anforderung, ein dazu eingerichtetes Computerprogramm sowie ein dazu eingerichtetes Testsystem.

### Stand der Technik

Der Validierungszyklus für Produkte ist ein wesentlicher Bestandteil der Entwicklung. Dabei wird überprüft, ob die angestrebten Qualitätsanforderungen im realen Betrieb erreicht werden. Um Sicherheitsrisiken im Vorhinein zu vermeiden, gilt es, möglichst viele Szenarien vorab zu testen. Diese Tests sind allerdings mit einem hohen Zeit- und Ressourcenaufwand verbunden. Da die Komplexität von technischen Systemen stetig steigt und dabei die Produktzyklen kürzer werden, sowie neue Funktionen und Ergänzungen von Produkten auch in Software ausgeliefert werden können, ist absehbar, dass die Anzahl an notwendigen Tests drastisch steigen wird. Um die aufwendige Validierung an einem realen System in dessen geplanter Anwendungsumgebung zu reduzieren, kann der Validierungszyklus mit Hilfe von zuverlässigen Simulationen in Software unterstützt werden. Dadurch lässt sich sowohl der Kostenaufwand als auch die notwendige Testzeit und damit die Time-to-Market deutlich verringern. Zudem können vor allem auch die Sicherheitsanforderungen an Produkte zuverlässiger und effizienter in computer-implementierten Testverfahren überprüft werden.

In der DE 20 2018 106888 wird ein Verfahren offenbart, mit welchem eine Testabdeckung für einen simulativen Test eines System bezüglich bestimmter Anforderungen berechnet wird, und mit dem abhängig von der Testabdeckung der Test fortgeführt oder beendet wird.

Aus der DE 10 2019 209538 ist ein Verfahren zur Auswahl von Tests zum Testen eines Systems bekannt.

Die DE 10 2019 209539 beschreibt Verfahren zum Beschreiben von durch Qualitätsattribute charakterisierte Anforderungen an eine Simulation.

### Offenbarung der Erfindung

Vorgestellt wird ein computerimplementiertes Verfahren zum Testen eines Systems auf mindestens eine Anforderung.

Das System umfasst dabei insbesondere ein Computerprogramm, eine Hardware oder ein eingebettetes System. Besonders vorteilhaft kann das Verfahren eingesetzt werden, wenn das getestete System ein Teilsystem eines zumindest teilautonomen Fahrzeugs oder eines zumindest teilautonomen Roboters ist oder dass das getestete System ein zumindest teilautonomes Fahrzeug oder ein zumindest teilautonomer Roboter ist.

Die Anforderung umfasst dabei insbesondere eine funktionale oder leistungsbezogene Anforderung oder eine Anforderung an die funktionale Sicherheit des Systems bei dessen (tatsächlicher) Ausführung.

In dem vorgestellten Verfahren wird die Anforderung in maschinenlesbarer Form empfangen. Für den Test des Systems auf die empfangene Anforderung wird mindestens eine erste Eingangsgröße ermittelt und eine Ausführung des Systems wird abhängig von der ermittelten ersten Eingangsgröße simuliert.

Weiterhin wird eine Ausgangsgröße des simulierten Systems ermittelt und abhängig von der Ausgangsgröße ermittelt, ob das System die Anforderung erfüllt.

Ferner wird überprüft, ob die Simulation eine Qualitätsanforderung erfüllt. Die Überprüfung umfasst dabei insbesondere eine Prüfung, ob die Simulation einen zulässigen Parameterbereich verlässt oder vorbestimmte Randbedingungen verletzt oder ob für die Simulation nötige Modelle oder Teilmodelle verfügbar sind.

Falls die Simulation die Qualitätsanforderung erfüllt und das System die Anforderung erfüllt, wird in dem vorgestellten Verfahren überprüft, ob für die Anforderung eine ausreichende Testabdeckung erreicht ist. Ist die ausreichende Testabdeckung für die Anforderung erreicht, wird der Test für die Anforderung abgeschlossen.

Somit wird ein besonders zuverlässiges und effizientes automatisiertes Testverfahren für simulative Tests von Systemen bereitgestellt. Durch eine permanente automatisiert ablaufende Überprüfung der eingesetzten Simulationen auf Qualitätsanforderungen und durch die entsprechende Berücksichtigung der Überprüfung für die Aktualisierung der Testabdeckung kann ein Testende zuverlässig nur abhängig von zulässigen Simulationen bestimmt werden. Die Gültigkeit des Testverfahrens wird ständig überprüft. Automatische Testgenerierung, Bewertung der Qualität des Testsystems und Bestimmung einer Testendebedingung werden miteinander verknüpft, so das ein automatisierter Testablauf auf einer virtuellen Plattform effizient umgesetzt werden kann.

In einer bevorzugten Ausgestaltung wird das Verfahren für eine nächste Anforderung fortgesetzt, bis alle verfügbaren Anforderungen abgearbeitet sind. So wird die Automatisierung des Testverfahrens auch über eine Anforderung bzw. einen Anforderungssatz ermöglicht, was die Effizienz des Testverfahrens weiter erhöht.

Falls die Testabdeckung nicht erreicht ist, wird vorzugsweise mindestens eine weitere Eingangsgröße abhängig von der Anforderung ermittelt wird und das System für die mindestens eine weitere Eingangsgröße simuliert wird. Es können insbesondere weitere Simulationen für weitere abhängig von der Anforderung ermittelte Eingangsgrößen erfolgen und entsprechende weitere Ausgangsgrößen durch das Testsystem überprüft werden, bis die Testabdeckung für die Anforderung erreicht ist. Somit wird das Verfahren automatisch fortgeführt, bis ein Testende automatisch festgestellt wird. Vorteilhafterweise wird die Simulation für eine Berechnung der Testabdeckung nicht berücksichtigt, falls die Simulation die Qualitätsanforderung nicht erfüllt.

In einer bevorzugten Ausgestaltung wird die weitere Eingangsgröße abhängig von einem Robustheitswert ermittelt wird, der beschreibt, wie gut das System für die erste Eingangsgröße die Anforderung erfüllt. Der Robustheitswert wird insbesondere abhängig von einer Ausgangsgröße des simulierten Systems ermittelt. Damit kann die Testfallgenerierung besonders effizient realisiert werden, beispielsweise mit Optimierungsverfahren wie Search-Based Testing.

In einer weiteren bevorzugten Ausgestaltung wird bei einer Verletzung der Anforderung in der Simulation für die erste Eingangsgröße ein Fehler festgestellt und der Fehler gespeichert und / oder ausgegeben. Dabei kann die Fehlerspeicherung und / oder die Fehlerausgabe insbesondere eine Information über die verletzte Anforderung und über die erste Eingangsgröße umfassen. Vorzugsweise umfasst die Fehlerausgabe oder Fehlerspeicherung eine Information über ein Maß der Verletzung der Anforderung. In einer besonders bevorzugten Variante erfolgt abhängig von dem festgestellten Fehler eine automatische Korrektur des Systems. Somit kann auf Basis der Tests die Fehlerfreiheit und Sicherheit des getesteten Systems sichergestellt bzw. automatisiert gleich hergestellt werden.

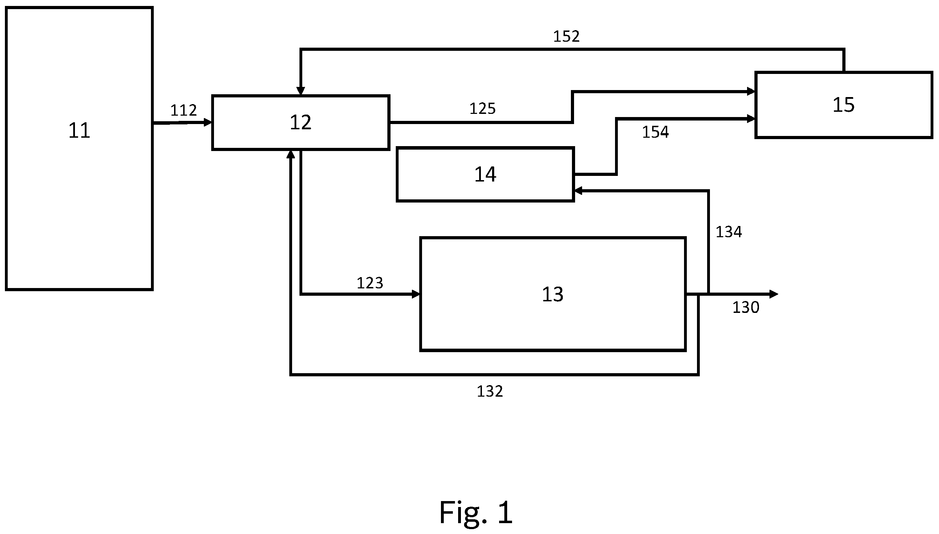

Nachfolgend werden Ausführungsformen der Erfindung unter Bezugnahme auf die beiliegende Zeichnung näher erläutert. Dabei zeigt Fig. 1 schematisch ein beispielhaftes Testsystem.

### Beschreibung der Ausführungsbeispiele

Für komplexe Systeme, z.B. elektronische Systeme, eingebettete Systeme, hydraulische oder mechatronische System, ist eine vollständige Überprüfung auf Anforderungen an das System bei ihrer Ausführung oft schwer zu realisieren, aufgrund von Sicherheitsanforderungen an die Systeme ist aber eine ausreichende Testabdeckung anzustreben. Gerade für teilautonome Systeme wie Fahrzeuge oder Roboter sind zuverlässige und effiziente Tests auf Sicherheitsanforderungen besonders bedeutend. Aufgrund reduzierter menschlicher Korrekturmöglichkeiten bei der tatsächlichen Ausführung des Systems und der drastischen Auswirkungen von Systemfehlern gelten besonders hohe Sicherheitsanforderungen. Gleichzeitig sind derartige Systeme äußerst flexibel und komplex und die für sie möglichen Szenarien und Umweltbedingungen kaum überschaubar. Auch für solche Systeme soll bereits in der Entwicklung deren Sicherheit für Nutzer und Umgebung sichergestellt werden.

Figur 1 zeigt schematisch eine beispielhafte Testumgebung bzw. ein beispielhaftes Testsystem zum Test eines Systems. Von einem Anforderungsmanagement 11 können maschinenlesbare Anforderungen zur Verfügung gestellt werden, auf welche das zu testende System getestet werden soll. In einem Block 12 können empfangene Anforderungen ausgewertet und formalisiert werden und für diese Testfälle bzw. entsprechende Eingangsgrößen ermittelt bzw. generiert werden. In einem Block 13 erfolgt eine Simulation des Systems für die ermittelten bzw. generierten Eingangsgrößen. In einem Block 14 kann abhängig von einer Ausgangsgröße der Simulation diese auf Qualitätsanforderungen überprüft werden. In einem Block 15 kann für den aktuellen Test bezüglich der damit getesteten Anforderung eine Testabdeckung bestimmt werden. In Block 12 kann abhängig von der Testabdeckung eine Fortführung oder eine Beendigung des Tests für diese Anforderung bestimmt werden. Zudem kann in Block 12 ein Robustheitsmaß bestimmt oder berücksichtigt werden, welches beschreibt, wie gut die Anforderung durch das System erfüllt wurde. Abhängig von der Anforderung und gegebenenfalls von dem Robustheitsmaß können in Block 12 bei einem fortgeführten Test weitere Eingangsgrößen für weitere Simulationen generiert werden.

Entsprechende Testverfahren werden am Beispiel eines Tests eines insbesondere teilautonomen Fahrzeugs beschrieben, welches im Rahmen einer Fahrzeugbewegungssteuerung autonome Notfallbremsungen veranlasst.

Für Untersuchungen im Rahmen von simulativen Tests an einem System stehen Ausgangsgrößen im Fokus, welche für das betrachtete System, insbesondere für eine bestimmte Anforderung an das System, eine besondere Relevanz besitzen. Typischerweise haben komplexere Systeme mehrere relevante Ausgangsgrößen.

Im Beispiel der Notfallbremsfunktion können das beispielsweise Gierrate, Längsgeschwindigkeit oder Längsbeschleunigung des Fahrzeugs sein.

Basis für die Tests sind Anforderungen aus dem Anforderungsmanagement bzw. Anforderungsmodul 11, welches z.B. gesetzliche Anforderungen, Anforderung aus der Spezifikation des Systems oder Anforderungen an eine funktionale Sicherheit des Systems maschinenlesbar zur Verfügung stellt.

Die Anforderungen werden dann in einem Schritt 112 an einen Block bzw. an ein Modul 12 übermittelt. Dort kann zur Unterstützung einer automatisierten und quantitativen Testgenerierung eine Beurteilung und Formalisierung der empfangenen Anforderungen erfolgen. Eine Formalisierung kann beispielsweise eine Übersetzung von maschinenlesbaren textlichen Anforderungen in Gleichungen, Formeln oder Funktionen umfassen, insbesondere für zeitvariante Anforderungen. Vorzugsweise werden Anforderung derart formalisiert, dass eine quantitative Auswertung einer Anforderungserfüllung und gegebenenfalls auch eines Erfüllungsgrad möglich wird. Die Anforderungen können dabei auch Randbedingungen an das System oder die Systemausführung umfassen. Verschiedene Anforderungen können auch für die weiteren Schritte kombiniert werden.

Für das Beispiel der Notfallbremsfunktion kann beispielsweise eine Anforderung empfangen werden, dass eine maximale Verzögerung bei einer Längsverzögerung nicht überschritten werden darf. Als Randbedingung kann zusätzlich auch eine Anforderung für den Test enthalten sein, dass der Test für einen bestimmten Eingangsgrößen- bzw. Parameterbereich an Reibwerten und für einen bestimmten Eingangsgrößen- bzw. Parameterbereich an Straßensteigungen erfüllt sein soll. Diese Anforderungen können dann ausgewertet und formalisiert und gegebenenfalls zu einer Anforderung kombiniert werden.

Anschließend erfolgt in Block 12 eine automatisierte Testfallgenerierung innerhalb eines definierten, durch die Anforderung vorgegebenen Parameterraums. Für die Testfallgenerierung können vorzugsweise Optimierungsmethoden wie Search-Based Testing eingesetzt werden. Dabei werden insbesondere gezielt Eingangsgrößen bzw. Parameter für die Simulationsmodelle ermittelt bzw. generiert, für welche eine Verletzung der Anforderung mit erhöhter Wahrscheinlichkeit erwartet wird. Durch den Einsatz von Optimierungsmethoden wie Search-Based Testing kann die Qualität der Testfallgenerierung und die Effizienz des Testverfahrens insgesamt deutlich gesteigert werden.

Block 13 empfängt die generierten Eingangsgrößen bzw. Simulationsparameter in Schritt 123 und simuliert das zu testende System abhängig von diesen. In der Simulation wird das System dabei anhand eines Systemmodells ausgeführt, welches insbesondere ein Streckenmodell umfasst. Anhand der Simulation wird das getestete System auf die formalisierte Anforderung hin geprüft.

In Block 12 kann anhand einer in Schritt 132 von Block 13 empfangenen Ausgangsgröße der Simulation ermittelt werden, ob die Anforderung erfüllt ist. Zusätzlich kann anhand der Ausgangsgröße auch ein Maß bestimmt werden, wie gut oder schlecht das System die Anforderung erfüllt bzw. nicht erfüllt (Robustheitsmaß). Abhängig von der Ausgangsgröße 132 und gegebenenfalls abhängig von dem Robustheitsmaß kann in Block 12 eine neue Eingangsgröße für eine weitere Simulation generiert bzw. ermittelt werden.

Bei der Testfallgenerierung können auch Tests generiert werden, bei denen das Testsystem oder die Testumgebung bzw. die Simulation in einem nicht gültigen Bereich betrieben wird. Z.B. kann ein verwendetes Modell nicht die benötigte Dynamik abbilden. Eine entsprechende Überprüfung der Simulation auf solche Qualitätsanforderungen und eine entsprechende Bewertung, ob oder wie die Qualitätsanforderung erfüllt wird, kann in Block 14 anhand einer Ausgangsgröße erfolgen, welche Block 14 in Schritt 134 von Block 13 empfängt. In Block 14 sind dafür Algorithmen für eine quantitative Bewertung einer Qualität der Simulationsumgebung bzw. verwendeter Simulationsmodelle gespeichert. Durch eine entsprechende Bewertung anhand objektivierter, quantitativer Qualitätsanforderungen wird die Belastbarkeit der entsprechenden Tests deutlich erhöht. Die Tests sind somit zuverlässiger und aussagekräftiger, beispielsweise auch als Entscheidungsgrundlage für die Verbesserung, Weiterentwicklung und Produktfreigabe eines Systems in Entwicklung.

Block 14 kann nun in Schritt 154 eine Größe ausgeben, welche beinhaltet, ob und gegebenenfalls wie eine Qualitätsanforderung an die Simulation durch diese erfüllt wird.

In Block 15 kann für das Testverfahren ein Maß für die Testabdeckung bezüglich einer bestimmten Anforderung bzw. einem Satz von Anforderungen ermittelt werden. Ein solches Testabdeckungsmaß wird vorzugsweise abhängig davon bestimmt, mit welcher Wahrscheinlichkeit das System die Anforderung verletzt, insbesondere für die noch nicht getesteten Eingangsgrößen bzw. Parameterraum.

Die Ermittlung erfolgt vorzugsweise abhängig von der in Schritt 125 von Block 12 erhaltenen Information darüber, ob und gegebenenfalls wie für die getestete Eingangsgröße das getestete System in der Simulation die getestete Anforderung erfüllt. Eine Berücksichtigung der Simulation für das ermittelte Testabdeckungsmaß kann dabei vorzugsweise abhängig von der in Schritt 154 von Block 14 erhaltenen Größe erfolgen, welche beinhaltet, ob und gegebenenfalls wie eine Qualitätsanforderung an die Simulation durch diese erfüllt wird.

Ergibt das Testabdeckungsmaß eine ausreichende Abdeckung, insbesondere durch Vergleich mit einer vorbestimmten Testabdeckung oder mit einer vorbestimmten Restwahrscheinlichkeit für Fehler, kann der Test für die aktuell getestete Anforderung bzw. den aktuell getesteten Satz an Anforderungen abgeschlossen werden. Ansonsten können mit weiteren Eingangsgrößen bzw. Simulationsparametern aus Block 12 weitere Tests am System für die Anforderung durchgeführt werden. Die entsprechende Information über Abschluss oder Fortführung der Tests kann von Block 15 in Schritt 152 an Block 12 übermittelt werden.

Block 15 bekommt also insbesondere eine das Testergebnis und die Information, ob die Testplattform in einem gültigen Bereich betrieben wurde und ermittelt daraus, ob die Anforderung bereits ausreichend wurde. Folgende Eingangsbedingungen und Konsequenzen können beispielsweise auftreten:
1) Anforderung durch das System erfüllt und Qualitätsanforderung an die Testumgebung erfüllt. Das Testergebnis wird für die Testabdeckung berücksichtigt.
2) Anforderung durch das System erfüllt, aber Qualitätsanforderung an die Testumgebung nicht erfüllt. Das Testergebnis wird für die Testabdeckung nicht berücksichtigt.
3) Anforderung durch das System nicht erfüllt, Qualitätsanforderung an die Testumgebung erfüllt. Das Testergebnis wird für die Testabdeckung berücksichtigt.
4) Anforderung durch das System nicht erfüllt und Qualitätsanforderung an die Testumgebung nicht erfüllt. Das Testergebnis wird für die Testabdeckung nicht berücksichtigt.

Im Beispiel der Notbremsfunktion ist beispielsweise eine Testabdeckung von größer 99% gefordert, z.B. entsprechend einer Restwahrscheinlichkeit für das Auftreten eines Fehlers im verbliebenen Eingangsgrößen- oder Parameterraum von kleiner 1%.

Für einen ersten Testfall werden als Eingangsgrößen ein erster Reibungswert und ein erster Steigungswert innerhalb der dafür jeweils zulässigen Parameterbereiche generiert und das System für diese simuliert. Die Simulation kann beispielsweise eine Ausführung des Systems für einen bestimmten Parameterbereich an Längsgeschwindigkeiten erfolgten. Als Ausgangsgröße der Simulation wird beispielsweise die dabei in der Simulation auftretende Längsverzögerung des Fahrzeugs beobachtet und ausgewertet. Erfüllt diese die getestete Anforderung, liegt also unterhalb der zulässigen maximalen Verzögerung, und erfüllt die Simulation die an sie gerichtete Qualitätsanforderung, so erhöht sich die Testabdeckung. Ergibt eine Überprüfung, dass die erforderliche Testabdeckung noch nicht erreicht ist, so wird ein neuer Test initiiert bzw. ein neuer Testfall generiert.

Für diesen zweiten Testfall wird ein noch nicht getestetes Paar aus Eingangsgrößen für Reibwert und Straßensteigung ermittelt, wiederum innerhalb der dafür jeweils zulässigen Parameterbereiche. Für diese Eingangsgrößen wird das System wiederum simuliert. Die Simulation kann beispielsweise auch wieder eine Ausführung des Systems für einen bestimmten Parameterbereich an Längsgeschwindigkeiten erfolgten. Als Ausgangsgröße der Simulation kann beispielsweise wieder die dabei in der Simulation auftretende Längsverzögerung des Fahrzeugs beobachtet und ausgewertet werden. Erfüllt diese die getestete Anforderung, liegt also unterhalb der zulässigen maximalen Verzögerung, erfüllt aber die Simulation die an sie gerichtete Qualitätsanforderung nicht, so wird die Simulation für die Testabdeckung nicht berücksichtigt. Beispielsweise kann eine Einregelung der Verzögerung durch einen ABS-Eingriff erfolgen, die Simulation bzw. das für die Simulation verwendetet Modell aber für einen solchen ABS-Eingriff unter denen gegebenen Randbedingungen und für die getesteten Eingangsgrößen kein ausreichendes Reifenmodell umfassen. Da die Testabdeckung durch die Simulation somit nicht erhöht wurde, wird ein neuer Test initiiert bzw. ein neuer Testfall generiert.

Für diesen dritten Testfall wird ein noch nicht getestetes Paar aus Eingangsgrößen für Reibwert und Straßensteigung ermittelt, wiederum innerhalb der dafür jeweils zulässigen Parameterbereiche. Für diese Eingangsgrößen wird das System wiederum simuliert. Die Simulation kann beispielsweise auch wieder eine Ausführung des Systems für einen bestimmten Parameterbereich an Längsgeschwindigkeiten erfolgten. Als Ausgangsgröße der Simulation kann beispielsweise wieder die dabei in der Simulation auftretende Längsverzögerung des Fahrzeugs beobachtet und ausgewertet werden. Erfüllt diese die getestete Anforderung nicht, liegt also oberhalb der zulässigen maximalen Verzögerung, so kann der entsprechende Fehler abgespeichert oder ausgegeben werden, es kann eine automatische Fehlerbehebung erfolgen und es kann auch der Test aufgrund des aufgetretenen Fehlers abgebrochen werden. Alternativ zu einem Abbruch aufgrund es aufgetretenen Fehlers kann die Simulation für eine Aktualisierung der Testabdeckung herangezogen werden, wenn die Simulation die an sie gerichtete Qualitätsanforderung erfüllt. Ergibt eine Überprüfung, dass die erforderliche Testabdeckung noch nicht erreicht ist, so wird ein neuer Test initiiert bzw. ein neuer Testfall generiert.

Für diesen vierten Testfall wird ein noch nicht getestetes Paar aus Eingangsgrößen für Reibwert und Straßensteigung ermittelt, wiederum innerhalb der dafür jeweils zulässigen Parameterbereiche. Für diese Eingangsgrößen wird das System wiederum simuliert. Die Simulation kann beispielsweise auch wieder eine Ausführung des Systems für einen bestimmten Parameterbereich an Längsgeschwindigkeiten erfolgten. Als Ausgangsgröße der Simulation kann beispielsweise wieder die dabei in der Simulation auftretende Längsverzögerung des Fahrzeugs beobachtet und ausgewertet werden. Erfüllt diese die getestete Anforderung, liegt also unterhalb der zulässigen maximalen Verzögerung, erfüllt die Simulation die an sie gerichtete Qualitätsanforderung, so kann die Simulation für eine Aktualisierung der Testabdeckung berücksichtigt werden. Ergibt eine Überprüfung, dass die erforderliche Testabdeckung von 99% nun erreicht ist, so wird der Test für diese getestete Anforderung abgeschlossen.

## Patentansprüche

1. Computerimplementiertes Verfahren zum Testen eines Systems (13) auf mindestens eine Anforderung **gekennzeichnet durch** die Schritte:
- die Anforderung (11) wird in maschinenlesbarer Form empfangen (112),
- für den Test des Systems (13) auf die empfangene Anforderung (11, 112) wird mindestens eine erste Eingangsgröße ermittelt (12),
- eine Ausführung des Systems (13) wird abhängig von der ermittelten ersten Eingangsgröße simuliert,
- eine Ausgangsgröße des simulierten Systems (13) wird ermittelt und abhängig von der Ausgangsgröße ermittelt, ob das System (13) die Anforderung erfüllt,
- es wird überprüft, ob die Simulation eine Qualitätsanforderung (14) erfüllt,
- falls die Simulation die Qualitätsanforderung erfüllt (14) und das System die Anforderung erfüllt (12), wird überprüft, ob für die Anforderung eine ausreichende Testabdeckung erreicht ist (15),
- ist die ausreichende Testabdeckung für die Anforderung erreicht (15), wird der Test für die Anforderung abgeschlossen.

2. Verfahren nach Anspruch 1, **dadurch gekennzeichnet, dass** das Verfahren für eine nächste Anforderung fortgesetzt wird, bis alle verfügbaren Anforderungen abgearbeitet sind.

3. Verfahren nach einem der vorangegangenen Ansprüche, **dadurch gekennzeichnet, dass**, falls die Testabdeckung nicht erreicht ist (15), mindestens eine weitere Eingangsgröße abhängig von der Anforderung ermittelt wird (12) und das System (13) für die mindestens eine weitere Eingangsgröße simuliert wird.

4. Verfahren nach Anspruch 3, **dadurch gekennzeichnet, dass** die weitere Eingangsgröße abhängig von einem Robustheitswert ermittelt wird (12), der beschreibt, wie gut das System (13) für die erste Eingangsgröße die Anforderung erfüllt.

5. Verfahren nach Anspruch 4, **dadurch gekennzeichnet, dass** der Robustheitswert abhängig von einer Ausgangsgröße (132) des simulierten Systems (13) ermittelt wird (12).

6. Verfahren nach einem der Ansprüche 3 bis 5, **dadurch gekennzeichnet, dass** weitere Simulationen für weitere abhängig von der Anforderung ermittelte Eingangsgrößen erfolgen und entsprechende weitere Ausgangsgrößen durch das Testsystem überprüft werden, bis die Testabdeckung für die Anforderung erreicht ist.

7. Verfahren nach einem der vorangegangenen Ansprüche, **dadurch gekennzeichnet, dass**, falls die Simulation die Qualitätsanforderung nicht erfüllt, die Simulation für eine Berechnung der Testabdeckung nicht berücksichtigt wird.

8. Verfahren nach Anspruch 7, **dadurch gekennzeichnet, dass** die Qualitätsanforderung eine Prüfung umfasst, ob die Simulation einen zulässigen Parameterbereich verlässt oder vorbestimmte Randbedingungen verletzt oder ob für die Simulation nötige Modelle oder Teilmodelle verfügbar sind.

9. Verfahren nach einem der vorangegangenen Ansprüche, **dadurch gekennzeichnet, dass** das getestete System (13) ein Computerprogramm, eine Hardware oder ein eingebettetes System umfasst.

10. Verfahren nach einem der vorangegangenen Ansprüche, **dadurch gekennzeichnet, dass** das getestete System (13) ein Teilsystem eines zumindest teilautonomen Fahrzeugs oder eines zumindest teilautonomen Roboters ist oder dass das getestete System (13) ein zumindest teilautonomes Fahrzeug oder ein zumindest teilautonomer Roboter ist.

11. Verfahren nach einem der vorangegangenen Ansprüche, **dadurch gekennzeichnet, dass** die Anforderung eine Anforderung an die funktionale Sicherheit des Systems umfasst.

12. Verfahren nach einem der vorangegangenen Ansprüche, **dadurch gekennzeichnet, dass** bei einer Verletzung der Anforderung in der Simulation für die erste Eingangsgröße ein Fehler festgestellt wird und dass der Fehler gespeichert und / oder ausgegeben wird.

13. Verfahren nach Anspruch 12, **dadurch gekennzeichnet, dass** die Fehlerspeicherung und / oder die Fehlerausgabe eine Information über die verletzte Anforderung und über die erste Eingangsgröße umfasst.

14. Verfahren nach Anspruch 13, **dadurch gekennzeichnet, dass** die Fehlerausgabe oder Fehlerspeicherung eine Information über ein Maß der Verletzung der Anforderung umfasst.

15. Verfahren nach einem der Ansprüche 12 bis 14, **dadurch gekennzeichnet, dass** abhängig von dem festgestellten Fehler eine automatische Korrektur des Systems erfolgt.

16. Computerprogramm, welches dazu eingerichtet ist, ein Verfahren nach einem der vorangegangenen Ansprüche durchzuführen.

17. Maschinenlesbarer Speicher, auf dem ein Computerprogramm nach Anspruch 16 gespeichert ist.

18. Testsystem, welches dazu eingerichtet ist, ein Verfahren nach einem der Ansprüche 1 bis 15 durchzuführen.

19. Testsystem nach Anspruch 18 mit einem Speicher nach Anspruch 17 und einem Prozessor zur Abarbeitung eines Computerprogramms nach Anspruch 16.
